# EUROPEAN PATENT APPLICATION

(11) **EP 4 350 793 A1**
(43) Date of publication of application: **10.04.2024**
(21) Application number: 22810927.8
(22) Date of filing: 11.03.2022
(51) Int. Cl.: H01L 51/46, H01L 21/28, H01L 21/288, H01L 51/50, H05B 33/26

(54) **COMPOSITION AND METHOD FOR PRODUCING ELECTRONIC DEVICE USING SAME**

(30) Priority: 24.05.2021 JP 2021087224
(71) Applicant: Panasonic Holdings Corporation, Osaka 571-8501 (JP)
(72) Inventor: HIGUCHI, Hiroshi, Kadoma-shi, Osaka 571-0057 (JP)
(74) Representative: Grünecker Patent- und Rechtsanwälte PartG mbB
(86) International application number: PCT/JP2022/010967
(87) International publication number: WO 2022/249648

(57) **Abstract**

A composition of the present disclosure comprises a conductive material, a p-type dopant, and a solvent. The solvent comprises at least one compound selected from the group consisting of alcohols, aliphatic hydrocarbons, siloxanes, esters, and ethers. A method of the present disclosure for manufacturing an electronic device comprises forming a second electrode 6 with the composition of the present disclosure and stacking a first electrode 2, a photoelectric conversion layer 3, a hole transport layer 5, and the second electrode 6 in the order stated.

## Description

### Technical Field

The present disclosure relates to a composition and methods for manufacturing an electronic device with the composition.

### Background Art

Many electronic devices have a structure for performing a function of light absorption, light emission, amplification, rectification, or the like. The structure includes a photoelectric conversion layer with which a hole transport layer or an electron transport layer is in contact. The structure allows holes alone or electrons alone to be extracted or supplied in one direction.

The hole transport layer is a layer that has a function of transferring and accepting holes to and from a valence band of the adjoining photoelectric conversion layer while blocking electrons from a conduction band of the photoelectric conversion layer. The electron transport layer is a layer that has a function of transferring and accepting electrons to and from the conduction band of the adjoining photoelectric conversion layer while blocking holes from the valence band of the photoelectric conversion layer.

There are various hole transport materials that can serve as a main material that forms the hole transport layer. However, there are few materials that have a hole concentration that enables the materials by themselves to sufficiently serve as hole transport layers for electronic devices. In many instances, a necessary hole concentration is achieved by adding an additive to the hole transport material. That is, the additive has a function of removing electrons from the valence band of the hole transport material.

Perovskite solar cells have a structure including, for example, a first electrode, a photoelectric conversion layer, a hole transport layer, and a second electrode that are formed in this order. In some instances, an electron transport layer is additionally disposed between the first electrode and the photoelectric conversion layer. In perovskite solar cells, the photoelectric conversion layer is a layer that absorbs light to generate electrons and holes. The hole transport layer is a layer that conducts only the holes generated in the photoelectric conversion layer to the second electrode while blocking the electrons. The electron transport layer is a layer that conducts only the electrons generated in the photoelectric conversion layer to the first electrode while blocking the holes (Non Patent Literature 1).

Organic thin film solar cells have a structure including, for example, a first electrode, a photoelectric conversion layer, a hole transport layer, and a second electrode that are formed in this order. Organic thin film solar cells differ from perovskite solar cells in some respects regarding details of the operating principle, but organic thin film solar cells are similar to perovskite solar cells in that the hole transport layer is a layer that conducts only holes without conducting electrons, to transmit the holes to the second electrode (Patent Literature 1).

Organic electroluminescent devices, which include an organic compound that serves as a light emitting layer, have a structure including, for example, a first electrode, the light emitting layer, a hole transport layer, and a second electrode that are formed in this order. The hole transport layer of organic electroluminescent devices is a functional layer that conducts only holes without conducting electrons to the light emitting layer and, therefore, operates differently than that of perovskite solar cells or organic thin film solar cells, described above. However, organic electroluminescent devices are similar to perovskite solar cells and organic thin film solar cells in that the hole transport layer has the function of conducting only holes without conducting electrons (Patent Literature 2).

Thus, the hole transport layer is a component that plays a central role in the operation of electronic devices. Unfortunately, there is a tendency for electronic devices to have degraded performance in instances in which the electrode on the hole transport layer is produced by the application of ink (Non Patent Literature 2).

Patent Literature 3 discloses an electrode containing a dopant with respect to an electron transport layer.

### Citation List

### Non Patent Literature

NPL 1: Materials Chemistry and Physics 256, p.123594 (2020)
NPL 2: Journral of Materials chemistry A, 3, p.15996 (2015)

### Patent Literature

PTL 1: Japanese Unexamined Patent Application Publication No. 2012-216673
PTL 2: Japanese Unexamined Patent Application Publication No. 2019-77685
PTL 3: International Publication No. 2011/052546

### Summary of Invention

### Technical Problem

An object of the present disclosure is to provide a composition suitable for improving the performance of electronic devices.

### Solution to Problem

A composition of the present disclosure comprises a conductive material, a p-type dopant, and a solvent. The solvent comprises at least one compound selected from the group consisting of alcohols, aliphatic hydrocarbons, siloxanes, esters, and ethers. Advantageous Effects of Invention

The present disclosure provides a composition suitable for improving the performance of electronic devices.

### Brief Description of Drawings

[Fig. 1] Fig. 1 is a flowchart illustrating an exemplary manufacturing method according to a second embodiment.
[Fig. 2] Fig. 2 is a cross-sectional view of a schematic configuration of a solar cell 100, which can be produced by the manufacturing method according to the second embodiment.
[Fig. 3] Fig. 3 is a cross-sectional view of a schematic configuration of a solar cell 200, which can be produced by the manufacturing method according to the second embodiment.
[Fig. 4] Fig. 4 is a flowchart illustrating an exemplary manufacturing method according to a third embodiment.
[Fig. 5] Fig. 5 is a cross-sectional view of a schematic configuration of a solar cell 300, which can be produced by the manufacturing method according to the third embodiment.
[Fig. 6] Fig. 6 is a cross-sectional view of a schematic configuration of a solar cell 400, which can be produced by the manufacturing method according to the third embodiment.

### Description of Embodiments

Embodiments of the present disclosure will be described below with reference to the drawings.

### (First Embodiment)

A composition will be described in a first embodiment below.

A composition according to the first embodiment comprises a conductive material, a p-type dopant, and a solvent. The solvent comprises at least one compound selected from the group consisting of alcohols, aliphatic hydrocarbons, siloxanes, esters, and ethers.

The composition according to the first embodiment is used, for example, as an ink for forming an electrode. The composition according to the first embodiment is used, for example, in an electronic device. Regarding the electronic device, for example, the electronic device including a first electrode, a photoelectric conversion layer, a hole transport layer, and a second electrode disposed in the order stated is, for example, a solar cell.

For example, in instances where the composition according to the first embodiment is used in the manufacture of an electrode of an electronic device, it is possible to inhibit a reduction in a hole concentration in the hole transport layer that may occur if, for example, a p-type dopant originally included in the hole transport layer is dissolved into the electrode. Accordingly, electronic devices fabricated with the composition according to the first embodiment can have improved performance.

In this specification, the "p-type dopant" is a material that serves as an acceptor when the material is added to a hole transport material that forms a hole transport layer of an electronic device, that is, a material that has a function of withdrawing electrons from a valence band of the hole transport material.

In this specification, the "hole transport material" is a material that allows injection and drainage of holes therethrough and prevents injection and drainage of electrons therethrough.

The conductive material is a material that allows injection and drainage of holes and electrons therethrough.

The conductive material may comprise at least one selected from the group consisting of metals, conductive carbons, and conductive compounds.

The conductive material may be a powder.

The metals may be any metals that can be formed into a powder. Note, however, that alkali metals and alkaline earth metals are somewhat unsuitable for use because they tend to combine with oxygen and water.

The conductive carbons are desirably ones that have high conductivity, from among those in a variety of forms made by different production methods. Examples of the conductive carbons include carbon black, graphene, carbon nanotubes, and graphite. The carbon black may be, for example, a carbon black manufactured by Mitsubishi Chemical Corporation, namely, #3030B, #3050B, #3230B, or #3400B.

Examples of the conductive compounds include fluorine-doped tin oxide (SnO₂:F), indium tin oxide (ITO), Al-doped zinc oxide (ZnO:Al), Ga-doped zinc oxide (ZnO:Ga), Nb-doped titanium oxide (TiO₂:Nb), barium tin oxide (BTO), and titanium nitride (TiN).

In instances where the conductive material is made of particles, the particles may have a particle diameter of less than or equal to 10 µm so as to facilitate ink production.

The p-type dopant may comprise at least one selected from the group consisting of metal salts comprising a bis(trifluoromethanesulfonyl)imide group; metal salts comprising a bis(fluorosulfonyl)imide group; metal salts comprising a bis(pentafluoroethylsulfonyl)imide group; metal salts comprising a 4,4,5,5-tetrafluoro-1,3,2-dithiazolidine-1,1,3,3-tetraoxide group; tris(pentafluorophenyl)borane (TPFPB); 2,3,5,6-tetrafluoro-7,7,8,8-tetracyanoquinodimethane (F4-TCNQ); SnCl₄; SbCl₅; FeCl₃; and WO₃.

The p-type dopant may be at least one selected from the group consisting of metal salts comprising a bis(trifluoromethanesulfonyl)imide group; metal salts comprising a bis(fluorosulfonyl)imide group; metal salts comprising a bis(pentafluoroethylsulfonyl)imide group; metal salts comprising a 4,4,5,5-tetrafluoro-1,3,2-dithiazolidine-1,1,3,3-tetraoxide group; TPFPB; F4-TCNQ; SnCl₄; SbCl₅; FeCl₃; and WO₃.

The p-type dopant may comprise at least one selected from the group consisting of lithium bis(trifluoromethanesulfonyl)imide (LiTFSI) and TPFPB. The p-type dopant may be at least one selected from the group consisting of LiTFSI and TPFPB.

The solvent may be any material that does not corrode the material that forms the surface onto which the composition is to be applied.

The solvent may comprise at least one selected from the group consisting of 1-propanol, 2-propanol, 1-butanol, 2-butanol, 1-pentanol, 2-pentanol, 3-pentanol, hexanol, heptanol, octanol, nonanol, decanol, undecanol, dodecanol, 1,2-propanediol, 1,3-propanediol, 1,2-pentadiol, 1,3-pentadiol, hexane, heptane, octane, nonane, decane, undecane, dodecane, hexamethyldisiloxane, hexamethoxydisiloxane, 1,1,3,3-tetramethyldisiloxane, 1,1,3,3,5,5,7,7,9,9,11,11-dodecamethylhexasiloxane, 1,1,5,5-tetramethyl-3,3-diphenyltrisiloxane, 1,1,1,3,3-pentamethyldisiloxane, methyl acetate, ethyl acetate, propyl acetate, butyl acetate, methyl cellosolve, ethyl cellosolve, propyl cellosolve, butyl cellsolve, dimethyl cellosolve, phenyl cellosolve, diisopropyl ether, ethylene glycol monoethyl ether acetate, propylene glycol monomethyl ether acetate, diethylene glycol monobutyl ether acetate, diethylene glycol monoethyl ether acetate, diethylene glycol monomethyl ether, diethylene glycol monoethyl ether, diethylene glycol monobutyl ether, propylene glycol monomethyl ether, propylene glycol monomethyl ether propionate, ethylene glycol dimethyl ether, diethylene glycol dimethyl ether, ethylene glycol diethyl ether, diethylene glycol diethyl ether, triethylene glycol dimethyl ether, diethylene glycol dibutyl ether, tetraethylene glycol dimethyl ether, and dipropylene glycol dimethyl ether.

These solvents are effective, for example, for perovskite solar cells and organic thin film solar cells.

The solvent may comprise 2-propanol.

The composition according to the first embodiment may include a binder. In this case, electrodes formed with the composition can have high cohesion.

Examples of the binder include polyvinylidene fluoride, polytetrafluoroethylene, polyhexafluoropropylene, polyethylene, polypropylene, polymethylmethacrylate, polyvinyl chloride, polyvinyl acetate, polyacrylic acid, polyvinyl butyral, polyacrylamide, polyurethane, polydimethyl siloxane, epoxy resins, acrylic resins, polyester resins, melamine resins, phenolic resins, various rubbers, lignins, pectins, gelatins, xanthan gums, welan gums, succinoglycans, polyvinyl alcohols, polyvinyl acetals, cellulose-based resins, polyalkylene oxides, polyvinyl ethers, polyvinylpyrrolidones, chitins, chitosans, and starches.

The composition according to the first embodiment may include a binder in an amount of greater than or equal to 2 mass% and less than or equal to 10 mass% based on a mass of the conductive material, so as to inhibit flocculation of the conductive material.

In the composition according to the first embodiment, a concentration of the p-type dopant may be greater than or equal to 0.1 mass% and less than 100 mass%. With this configuration, a reduction in a dopant concentration in the hole transport layer can be inhibited.

In the composition according to the first embodiment, the concentration of the p-type dopant may be greater than or equal to 0.1 mass% and less than or equal to a saturation concentration in the solvent. With this configuration, a reduction in the dopant concentration in the hole transport layer can be inhibited. Furthermore, during the storage of the composition, evaporation of the solvent can be inhibited. The concentration of the p-type dopant may be greater than or equal to 0.1 mass% and less than or equal to 50 mass% or greater than or equal to 0.1 mass% and less than or equal to 46.1 mass%. In this case, a reduction in the dopant concentration in the hole transport layer can be further inhibited. Furthermore, an increase in viscosity of the composition can be inhibited, and, consequently, film forming by spin coating can be facilitated.

### (Second Embodiment)

A method for manufacturing an electronic device with the composition according to the first embodiment will be described in a second embodiment below.

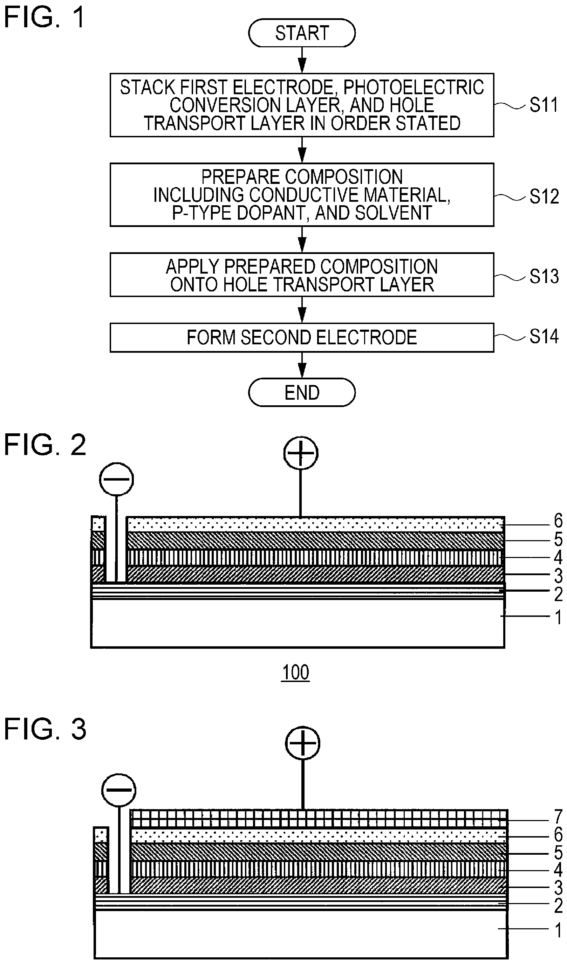

Fig. 1 is a flowchart illustrating an exemplary manufacturing method according to the second embodiment.

The method for manufacturing an electronic device according to the second embodiment comprises
(A1) stacking a first electrode, a photoelectric conversion layer, and a hole transport layer in the order stated; and
(B 1) forming a second electrode on the hole transport layer with the composition according to any one of claims 1 to 8.

In Fig. 1, regarding the steps in the flowchart illustrating the exemplary manufacturing method according to the second embodiment, S11 is encompassed by (A1), and S12 to S 14 are encompassed by (B 1).

In (B 1), the second electrode may be formed by applying the composition according to the first embodiment onto the hole transport layer.

In the related art, in the instance where an electrode is produced by applying ink onto a hole transport layer, performance tends to be degraded. This is because, in such a case, a p-type dopant present in the hole transport layer is dissolved into the electrode, and, consequently, a hole concentration in the hole transport layer is reduced. The manufacturing method according to the second embodiment produces an electrode by applying the composition according to the first embodiment onto the hole transport layer. In the second embodiment, since the composition includes a p-type dopant, it is possible to inhibit a reduction in a p-type dopant concentration in the hole transport layer that may occur if the p-type dopant is dissolved into the electrode from the hole transport layer. As a result, a reduction in the hole concentration in the hole transport layer can be inhibited. Accordingly, the manufacturing method according to the second embodiment can provide electronic devices having improved performance.

In (A1), the first electrode, the photoelectric conversion layer, and the hole transport layer may be stacked on a substrate in the order stated.

In (A1), the first electrode, an electron transport layer, the photoelectric conversion layer, and the hole transport layer may be stacked in the order stated.

The electronic device that is manufactured by the manufacturing method according to the second embodiment may be any electronic device that includes a first electrode, a photoelectric conversion layer, a hole transport layer, and a second electrode disposed in the order stated. The electronic device that is manufactured by the manufacturing method according to the second embodiment may be, for example, a solar cell, a light emitting element, or an optical sensor. The electronic device that is manufactured by the manufacturing method according to the second embodiment may be, for example, a solar cell.

An exemplary configuration of an electronic device that is manufactured by the manufacturing method according to the second embodiment will be described with reference to Figs. 2 and 3. The electronic device in this case is a solar cell.

Fig. 2 is a cross-sectional view of a schematic configuration of a solar cell 100, which can be produced by the manufacturing method according to the second embodiment. The solar cell 100 includes a substrate 1, a first electrode 2, an electron transport layer 3, a photoelectric conversion layer 4, a hole transport layer 5, and a second electrode 6, which are stacked in the order stated.

The manufacturing method according to the second embodiment may further include
(C1) stacking an auxiliary electrode on the second electrode.

In this case, a current from the second electrode of the resulting electronic device can be extracted to an outside without incurring much loss.

Fig. 3 is a cross-sectional view of a schematic configuration of a solar cell 200, which can be produced by the manufacturing method according to the second embodiment. The solar cell 200 includes the substrate 1, the first electrode 2, the electron transport layer 3, the photoelectric conversion layer 4, the hole transport layer 5, the second electrode 6, and an auxiliary electrode 7, which are stacked in the order stated.

The first electrode 2 may be a negative electrode and have an exposed portion. In this case, the manufacturing method may include removing portions of the electron transport layer 3, the photoelectric conversion layer 4, the hole transport layer 5, the second electrode 6, and the auxiliary electrode 7 corresponding to the portion of the first electrode 2 that is to be exposed, and the removing may be carried out, for example, by performing laser scribing with laser irradiation or by performing mechanical scribing with a metal knife.

Constituent elements of a solar cell that is manufactured by the manufacturing method according to the second embodiment will be described below.

### (Substrate 1)

The substrate 1 serves to hold the layers of the solar cell. The substrate 1 is formed of a stable material that does not corrode or disappear during the steps of forming the first electrode 2, the photoelectric conversion layer 4, the hole transport layer 5, and the second electrode 6, on the substrate 1.

In instances where the solar cell is one that generates electricity from light coming from a substrate side, the material that forms the substrate 1 is a light-transmissive material.

The substrate 1 may be a ceramic substrate made of glass or the like or may be a plastic substrate. The plastic substrate may be a plastic film.

When the first electrode 2 has sufficient strength, the first electrode 2 can hold the layers of the solar cell, and, therefore, the substrate 1 need not be provided.

### (First Electrode 2)

A function of the first electrode 2 is to accept electrons generated in the photoelectric conversion layer 4 and allow the electrons to be extracted to an outside. The first electrode 2 is conductive. It is desirable that the first electrode 2 have low electrical resistance.

Examples of the material that forms the first electrode 2 include metals, conductive compounds that are electron conductive, and conductive carbons.

The metals are not limited, and substantially any metal may be used.

In instances where the first electrode 2 needs to be light-transmissive, it is desirable that the material be a light-transmissive conductive compound. Examples of the conductive compound include oxides of indium, zinc, or tin; oxides and nitrides of titanium; and organic conductive materials. Fluorine-doped tin oxide (SnO₂:F), indium tin oxide (ITO), Al-doped zinc oxide (ZnO:Al), Ga-doped zinc oxide (ZnO:Ga), Nb-doped titanium oxide (TiO₂:Nb), and barium tin oxide (BTO) have a low volume resistivity value. Accordingly, these can be used in solar cells for outdoor use, through which a large current is to be passed. SnO₂:F, ITO, ZnO:Al, ZnO:Ga, TiO₂:Nb, and BTO are also light-transmissive and, therefore, particularly useful for solar cells.

Examples of the conductive carbons include carbon blacks, carbon nanotubes (CNT), graphene, and graphite. Ketjen black and acetylene black are materials that are classified as carbon blacks.

Examples of methods for producing the first electrode 2 include vacuum deposition methods, such as sputtering, vapor deposition, and ion plating, screen printing, spray methods, and chemical vapor deposition (CVD) methods. The CVD method is a method that forms a film on a surface of the substrate 1 by injecting fine droplets or gas of a special material liquid onto the substrate 1 that has been heated. For example, the first electrode 2 may be produced by sputtering ITO onto the substrate 1 such that a sheet resistance of approximately greater than or equal to 10 Ω/□ and less than or equal to 40 Ω/□ is achieved.

### (Electron Transport Layer 3)

A function of the electron transport layer 3 is to accept electrons from the conduction band of the photoelectric conversion layer 4 and conduct the electrons to the first electrode 2, while blocking holes from the valence band of the photoelectric conversion layer 4.

Examples of the material that forms the electron transport layer 3 include titanium oxide and tin oxide.

Examples of methods for producing the electron transport layer 3 include a method in which a dispersion of TiO₂ nanoparticles in alcohol (concentration: 1 mass%) is applied by spinning or spraying, and thereafter, the alcohol is removed by applying heat at greater than or equal to 100°C. For example, the electron transport layer 3 may be produced by sputtering TiO₂ onto the first electrode 2 to a thickness of greater than or equal to 10 nm and less than or equal to 100 nm. In addition, an assembly of TiO₂ nanoparticles may be formed with a thickness of approximately greater than or equal to 100 nm and less than or equal to 500 nm, to provide the electron transport layer 3.

### (Photoelectric Conversion Layer 4)

A function of the photoelectric conversion layer 4 is to receive light coming from the substrate side or a side opposite thereto to generate electrons and holes and diffuse the electrons and the holes without allowing the electrons and the holes to recombine.

The photoelectric conversion layer 4 may contain a perovskite compound. The "perovskite compound" is a compound having a perovskite-type crystal structure represented by the composition formula of ABX₃ or a structure similar thereto. In the formula, A is a monovalent cation. Examples of the cation A include monovalent cations such as alkali metal cations and organic cations. Examples of the alkali metal cations include sodium cations (Na⁺), potassium cations (K⁺), cesium cations (Cs⁺), and rubidium cations (Rb⁺). Examples of the organic cations include methyl ammonium cations (CH₃NH₃⁺) and formamidinium cations (NH₂CHNH₂⁺). B is a divalent metal cation. Examples of the cation B include Pb cations, Sn cations, and Ge cations. X is a monovalent anion. Examples of the anion X include halogen anions. Examples of the halogen anions include iodine anions and bromine anions. The sites of the cation A, the cation B, and the anion X may each be occupied by more than one type of ion.

Examples of methods for producing the photoelectric conversion layer 4 include a method in which a solution containing specified materials dissolved in an organic solvent is applied, thereafter, the organic solvent is removed from the applied film, and thereafter, the resultant is heat-treated. The removal of the organic solvent from the applied film can be accomplished, for example, in either of the following ways or the like. One possible way is to reduce pressure, thereby volatilizing and removing the organic solvent. Another possible way is to add another solvent that is a poor solvent with respect to the specified materials dissolved in the organic solvent and which is compatible with the organic solvent, thereby exclusively removing the organic solvent from the applied film. These methods are common. These methods are simple and can produce a photoelectric conversion layer 4 having high performance. The methods for producing the photoelectric conversion layer 4 may include vacuum vapor deposition.

### (Hole Transport Layer 5)

A function of the hole transport layer 5 is to accept only holes from the photoelectric conversion layer 4 while blocking electrons. The hole transport layer 5 contains a hole transport material. It is desirable that the hole transport material have a HOMO (Highest Occupied Molecular Orbital) level close to the HOMO level of the photoelectric conversion layer 4 and a LUMO (Lowest Unoccupied Molecular Orbital) level higher than the LUMO level of the photoelectric conversion layer 4.

For example, in the instance of perovskite solar cells, the LUMO level of the photoelectric conversion layer 4 is approximately -4 eV, and the HOMO level thereof is approximately -5 eV. Accordingly, examples of the hole transport material include poly(bis(4-phenyl)(2,4,6-trimethylphenyl))amine(PTAA),N²,N²,N^{2'},N^{2'},N⁷,N⁷,N^{7'},N^{7'}-octakis(4-methoxyphenyl)-9,9'-spirobi[9H-fluorene]-2,2',7,7'-tetraamine (Spiro-OMeTAD), dithiophene-benzene copolymers (DTB), poly(3-hexylthiophene) (P3HT), and poly(3-hexylthiophene)-polystyrene block polymers (P3HT-b-PSt).

The hole transport layer 5 may contain at least one selected from the group consisting of PTAA, spiro-OMeTAD, DTB, P3HT, and P3HT-b-PSt. Note that these materials may not be able to provide a sufficient hole density of the hole transport layer by themselves. Accordingly, the hole transport layer 5 may include not only the hole transport material but also an additive. The additive has a function of removing electrons from the valence band of the hole transport material. That is, the hole transport layer 5 may include a p-type dopant. In the following description, the p-type dopant that is included in the hole transport layer 5 is also referred to as a "second p-type dopant".

The second p-type dopant may be any of the materials mentioned above as examples of the material of the p-type dopant that is included in the composition according to the first embodiment. The second p-type dopant that may be included in the hole transport layer 5 may be a material that is the same as or different from the material of the p-type dopant that is included in the composition according to the first embodiment. When the materials of the p-type dopants to be included in the hole transport layer 5 and the composition according to the first embodiment, which forms the second electrode 6, are the same, the electronic device can be produced by a simple process. When the materials of the p-type dopants to be included in the hole transport layer 5 and the composition according to the first embodiment, which forms the second electrode 6, are different from each other, p-type dopants having different properties can be used in the electronic device, and, therefore, the properties of the p-type dopants can be complementary to each other. For example, in instances where the hole transport layer 5 and the second electrode 6 contain a p-type dopant that is resistant to light and a p-type dopant that is resistant to heat, the resistance of the electronic device to light and heat can be improved.

The hole transport layer 5 may be formed in the following manner: a hole transport material and a second p-type dopant are dissolved in an organic solvent, and the resulting liquid is applied onto a layer that serves as an underlayer (e.g., the photoelectric conversion layer 4) and dried. The organic solvent to be used is, for example, an organic solvent that does not dissolve the first electrode 2, the electron transport layer 3, and the photoelectric conversion layer 4. Examples of such organic solvents include benzene, chlorobenzene, toluene, xylene, anisole, and mesitylene.

### (Second Electrode 6)

A function of the second electrode 6 is to accept holes generated in the photoelectric conversion layer 4 and allow the holes to be extracted to an outside.

The second electrode 6 is formed with the composition according to the first embodiment. For example, the second electrode 6 can be formed by applying and drying the composition according to the first embodiment. For example, the second electrode 6 may be formed by applying the composition to the hole transport layer and drying the composition. In this case, a reduction in the dopant concentration in the hole transport layer 5 can be further inhibited. As a result, the performance of the electronic device can be improved.

### (Auxiliary Electrode 7)

The auxiliary electrode 7 is electrically connected to the second electrode 6. A function of the auxiliary electrode 7 is to allow a current from the second electrode 6 to be extracted to an outside without incurring much loss. The auxiliary electrode 7 may be formed of a low-resistance material. The auxiliary electrode 7 is formed, for example, by vapor deposition.

### (Third Embodiment)

A method for manufacturing an electronic device with the composition according to the first embodiment will be described in a third embodiment. Some of the descriptions given in the first embodiment and the second embodiment may not be repeated.

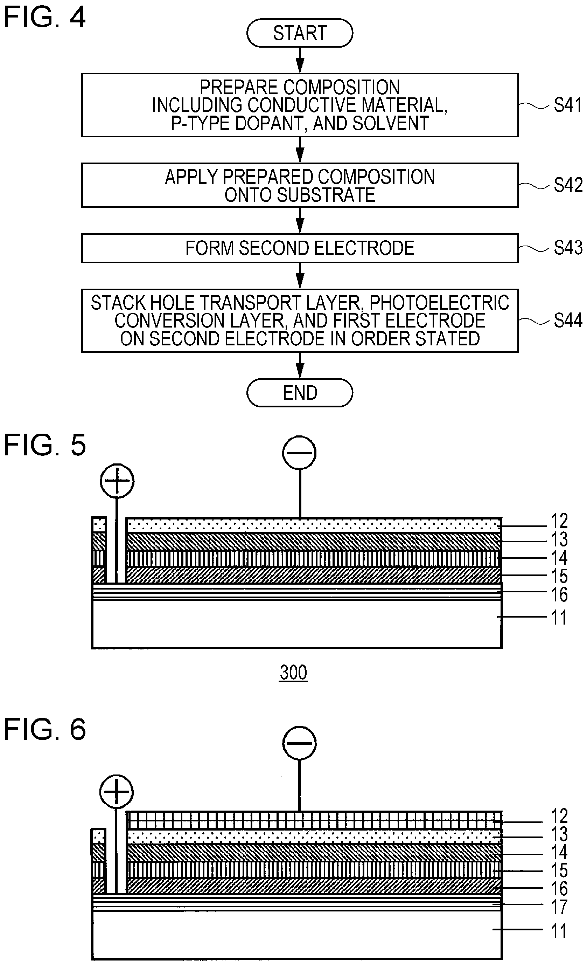

Fig. 4 is a flowchart illustrating an exemplary manufacturing method according to the third embodiment.

The method for manufacturing an electronic device according to the third embodiment comprises
(A2) forming a second electrode with the composition according to any one of claims 1 to 8; and
(B2) stacking a hole transport layer, a photoelectric conversion layer, and a first electrode on the second electrode in the order stated.

In Fig. 4, regarding the steps in the flowchart illustrating the exemplary manufacturing method according to the third embodiment, S41 to S43 are encompassed by (A2), and S44 is encompassed by (B2).

In (A2), the second electrode may be formed by applying the composition according to the first embodiment to a substrate.

In (B2), the hole transport layer, the photoelectric conversion layer, an electron transport layer, and the first electrode may be stacked on the second electrode in the order stated.

The electronic device that is manufactured by the manufacturing method according to the third embodiment may be, for example, a solar cell.

An exemplary configuration of an electronic device that is manufactured by the manufacturing method according to the third embodiment will be described with reference to Figs. 5 and 6. The electronic device in this case is a solar cell.

Fig. 5 is a cross-sectional view of a schematic configuration of a solar cell 300, which can be produced by the manufacturing method according to the third embodiment. The solar cell 300 includes a substrate 11, a second electrode 16, a hole transport layer 15, a photoelectric conversion layer 14, an electron transport layer 13, and a first electrode 12, which are stacked in the order stated.

The manufacturing method according to the third embodiment may further include
(C2) stacking an auxiliary electrode on the second electrode.

In this case, a current from the second electrode of the resulting electronic device can be extracted to an outside without incurring much loss.

Fig. 6 is a cross-sectional view of a schematic configuration of a solar cell 400, which can be produced by the manufacturing method according to the third embodiment. The solar cell 400 includes the substrate 11, the second electrode 16, an auxiliary electrode 17, the hole transport layer 15, the photoelectric conversion layer 14, the electron transport layer 13, and the first electrode 12, which are stacked in the order stated.

Constituent elements of a solar cell that is manufactured by the manufacturing method according to the third embodiment will be described below. Some of the descriptions given in the second embodiment may not be repeated.

The substrate 11 has the same configuration as the substrate 1, described in the second embodiment. The auxiliary electrode 17 has the same configuration as the auxiliary electrode 7, described in the second embodiment. The hole transport layer 15 has the same configuration as the hole transport layer 5, described in the second embodiment. The photoelectric conversion layer 14 has the same configuration as the photoelectric conversion layer 4, described in the second embodiment. The electron transport layer 13 has the same configuration as the electron transport layer 3, described in the second embodiment. The first electrode 12 has the same configuration as the first electrode 2, described in the second embodiment.

The second electrode 16 is formed with the composition according to the first embodiment. For example, the second electrode 16 can be formed by applying and drying the composition according to the first embodiment. For example, the second electrode 16 may be formed by applying the composition to the substrate 1 and drying the composition. In this case, a reduction in the hole concentration in the hole transport layer 15 can be inhibited. As a result, the electronic device provided has improved performance.

The method for producing the hole transport layer 15 is as described above in the second embodiment.

Examples of methods for producing the photoelectric conversion layer 14 include a method in which a solution containing specified materials dissolved in an organic solvent is applied, thereafter, pressure is reduced to vaporize and remove the organic solvent, and thereafter, the resultant is heat-treated.

Examples of methods for producing the electron transport layer 13 include a method in which TiO₂ or SnO₂ is sputtered. Alternatively, the electron transport layer 13 may be formed as follows: a dispersion of TiO₂ nanoparticles in alcohol (concentration: 1 mass%) is applied by spinning or spraying, thereafter, the alcohol is removed by applying heat at greater than or equal to 100°C, and subsequently, TiO₂ or SnO₂ is sputtered.

Examples of methods for producing the first electrode 12 include vacuum deposition, such as sputtering and vapor deposition, which may be performed with indium tin oxide (ITO), Al-doped zinc oxide (ZnO:Al), Ga-doped zinc oxide (ZnO:Ga), Nb-doped titanium oxide (TiO2:Nb), or barium tin oxide (BTO).

### EXAMPLES

The present disclosure will now be described in more detail with reference to examples. In the examples, perovskite solar cells were produced, and the device performance thereof was evaluated.

### (Examples 1 to 9)

The method used to produce the solar cells of Examples 1 to 9 will be described below.

A sheet of glass measuring 25 mm × 25 mm × 0.7 mm thick was prepared to be used as a substrate. Indium tin oxide (ITO) was formed on one side of the glass by sputtering such that a sheet resistance of 10 Ω/□ was achieved by sputtering. In this manner, the first electrode was formed on the substrate.

Titanium oxide (TiO₂) was sputtered onto the first electrode to a thickness of 30 nm.

In addition, a nanoparticle assembly of TiO₂ was formed with a thickness of 250 nm. In this manner, the electron transport layer was formed on the first electrode.

Next, a raw material solution for the photoelectric conversion layer was prepared. The raw material solution was a liquid in which 2.91 g of formamidinium hydroiodide ((NH₂)₂CH₂I), 0.57 g of methyl ammonium hydroiodide (CH₃NH₃I), and 10 g of lead iodide (PbI₂) were dissolved in a solvent mixture of 23.3 mL of N,N-dimethylformamide (DMF) and 5.8 mL of dimethyl sulfoxide (DMSO). The raw material solution (80 µL) was added dropwise onto the electron transport layer, and then, the substrate including the electron transport layer was rotated in a spin coater at 4000 rpm for 70 seconds. After 30 to 60 seconds elapsed from the start of the rotation, 1 mL of toluene was pipetted onto the electron transport layer that was being rotated, which included the raw material solution added dropwise thereto. Subsequently, the resultant was heated on a hot plate at 115°C for 30 minutes. In this manner, the photoelectric conversion layer was formed on the electron transport layer.

Next, a hole transport material liquid was prepared. The hole transport material liquid was prepared by adding 4.8 µL of a solution, in which 500 mg of LiTFSI was dissolved in 1 mL of acetonitrile, to a solution prepared by adding 10 mg of PTAA and 6 µL of tert-butylpyridine to 1 mL of toluene. The hole transport layer was formed by a process in which 60 µL of the hole transport material liquid was added dropwise onto the photoelectric conversion layer, and then, rotation was applied at 4000 rpm for 30 seconds with a spin coater.

A composition of the present disclosure was prepared to be used as an ink for an electrode. The ink for an electrode was adjusted as follows. 9 parts by mass of acetylene black and 1 part by mass of cellulose were added to a bead mill, thereafter, 2-propanol, in the amount shown in Table 1, was added thereto, and the contents were stirred. Subsequently, LiTFSI or TPFPB, which was used as the p-type dopant, was added in the amount shown in Table 1. Table 1 shows a concentration of the p-type dopant in the ink for an electrode. The concentration of the p-type dopant in the ink for an electrode is a mass fraction of the p-type dopant in the ink for an electrode.

500 µL of the ink for an electrode (composition) was added dropwise onto the hole transport layer, then, rotation was applied at 1000 rpm for 30 seconds with a spin coater, and subsequently, the resultant was heated on a hot plate at 100°C for 2 hours. In this manner, the second electrode was formed on the hole transport layer. Au was formed on the second electrode to a thickness of 200 nm by vapor deposition. In this manner, an auxiliary electrode was formed.

In the manner described above, the solar cells of Examples 1 to 9 were produced.

### (Comparative Example 1)

A solar cell of Comparative Example 1 was produced as in Examples 1 to 9, except that no p-type dopant was added to the ink for an electrode that was added dropwise onto the hole transport layer.

### (Evaluation 1)

A property of the produced solar cells of Examples 1 to 9 and Comparative Example 1 was evaluated under fluorescent light. The fluorescent light (illuminance: 200 lx) was projected onto the solar cells in a manner such that the light entered the solar cells from the glass surface side, the glass being the substrate. The glass surface had a light-blocking mask attached thereto, and the light-blocking mask had an opening area shape of 0.4 cm × 0.25 cm, so that a light-receiving area could be defined. A current value at an operating voltage of 0.6 V was measured with a source meter (6246, manufactured by ADC Corporation). Hereinafter, the operating voltage is also referred to as "Vop". Table 1 shows the current values at Vop=0.6 V at an illuminance of 200 lx of the solar cells of Examples 1 to 9 and Comparative Example 1.

### (Evaluation 2)

A property of the produced solar cells of Examples 1 to 9 and Comparative Example 1 was evaluated under simulated sunlight. The light, at 1 sun intensity, was projected onto the solar cells with a solar simulator in a manner such that the light entered the solar cells, via a light-blocking mask, from the glass surface side, the glass being the substrate. The light-blocking mask had an opening area shape of 0.4 cm × 0.25 cm. A voltage-current characteristic over a voltage range of -0.2 V to +1.2 V was measured with a source meter (6246, manufactured by ADC Corporation), and the power at a maximum power point was determined. Table 1 shows the maximum powers of the solar cells of Examples 1 to 9 and Comparative Example 1.

**[Table 1]**

| | Composition of ink for second electrode | | | | | P-type dopant concentration in composition (wt/wt) | 200-lx performance | 1-SUN performance |
|---|---|---|---|---|---|---|---|---|
| | Acetylene black (g) | Cellulose (g) | LiTFSI (g) | TPFPB (g) | 2-Propanol (g) | | Current at Vop=0.6 V (µA/cm²) | Maximum power mW/cm² |
| Comparative Example 1 | 9.0 | 1.0 | 0.00 | 000 | 30.7 | 0 | 9.4 | 2.23 |
| Example 1 | 9.0 | 1.0 | 0.04 | 000 | 30.8 | 0.001 | 13.9 | 11.33 |
| Example 2 | 9.0 | 1.0 | 0.17 | 0.00 | 31.0 | 0.004 | 24.6 | 13.44 |
| Example 3 | 9.0 | 1.0 | 1.62 | 0.00 | 33.2 | 0.036 | 16.5 | 14.63 |
| Example 4 | 9.0 | 1.0 | 4.85 | 0.00 | 38.1 | 0.091 | 16.9 | 12.36 |
| Example 5 | 9.0 | 1.0 | 9.69 | 0.00 | 45.5 | 0.149 | 26.3 | 17.37 |
| Example 6 | 9.0 | 1.0 | 17.4 | 0.00 | 30.7 | 0.299 | 24.3 | 13.32 |
| Example 7 | 9.0 | 1.0 | 34.8 | 000 | 30.7 | 0.461 | 22.2 | 10.85 |
| Example 8 | 9.0 | 1.0 | 0.00 | 1.62 | 33.2 | 0.036 | 23.4 | 12.57 |
| Example 9 | 9.0 | 1.0 | 0.00 | 4.85 | 38.1 | 0.091 | 23.6 | 11.98 |

### (Discussion 1)

As shown in Table 1, the current values regarding Evaluation 1 and the values of the maximum power regarding Evaluation 2 of Examples 1 to 7 are greater than those of Comparative Example 1. The use of the ink for an electrode containing LiTFSI, which is a p-type dopant, for the formation of the second electrode improves the properties of the solar cells. Furthermore, the properties of the solar cells are improved when the concentration of LiTFSI in the ink for an electrode is within a range of 0.1 mass% to 46.1 mass%.

The current values regarding Evaluation 1 and the values of the maximum power regarding Evaluation 2 of Examples 8 and 9 are greater than those of Comparative Example 1. This indicates that even when the p-type dopant included in the ink for an electrode is TPFPB while the p-type dopant originally included in the hole transport layer is LiTFSI, the properties of the solar cells are improved. That is, it was demonstrated that the p-type dopant to be included in the ink for an electrode is not limited to the dopant present in the hole transport layer, that is, may be a different material.

### (Examples 10 to 18)

The method used to produce the solar cells of Examples 10 to 18 will be described below. The components other than the hole transport layer or the second electrode were produced as in Examples 1 to 9, and, therefore, descriptions thereof are not provided here.

The hole transport layer was formed by a process in which 0.06 mL of a hole transport material liquid was added dropwise onto a semiconductor layer, and then, rotation was applied at 4000 rpm for 30 seconds with a spin coater. The hole transport material liquid was prepared by adding 0.1 g of PTAA to a glass container, then, adding 10 mL of a TPFPB solution thereto, and shaking the container for 2 hours. The TPFPB solution was prepared by dissolving 1 g of a TPFPB powder in 10 mL of toluene. That is, the hole transport layers of Examples 10 to 18 were different from those of Examples 1 to 9 in that the p-type dopant that was included was TPFPB.

A composition of the present disclosure was adjusted to be used as an ink for an electrode. The ink for an electrode was adjusted as follows. 9 parts by mass of acetylene black and 1 part by mass of cellulose were added to a bead mill, thereafter, 2-propanol, in the amount shown in Table 2, was added thereto, and the contents were stirred. Subsequently, LiTFSI or TPFPB, which was used as the p-type dopant, was added in the amount shown in Table 2. Table 2 shows a concentration of the p-type dopant in the ink for an electrode.

500 µL of the ink for an electrode was added dropwise onto the hole transport layer, then, rotation was applied at 1000 rpm for 30 seconds with a spin coater, and subsequently, the resultant was heated on a hot plate at 100°C for 2 hours. In this manner, the second electrode was formed on the hole transport layer. Au was formed on the second electrode to a thickness of 200 nm by vapor deposition. In this manner, an auxiliary electrode was formed.

### (Comparative Example 2)

A solar cell of Comparative Example 2 was produced as in Examples 10 to 18, except that no p-type dopant was added to the ink for an electrode.

### (Evaluation 3)

A property of the produced solar cells of Examples 10 to 18 and Comparative Example 2 was evaluated under fluorescent light. The fluorescent light (illuminance: 200 lx) was projected onto the solar cells in a manner such that the light entered the solar cells from the glass surface side, the glass being the substrate. The glass surface had a light-blocking mask attached thereto, and the light-blocking mask had an opening area shape of 0.4 cm × 0.25 cm, so that a light-receiving area could be defined. A current value at an operating voltage of 0.6 V was measured with a source meter (6246, manufactured by ADC Corporation). Table 2 shows the current values at Vop=0.6 V at an illuminance of 200 lx of the solar cells of Examples 10 to 18 and Comparative Example 2.

### (Evaluation 4)

A property of the produced solar cell devices of Examples 10 to 18 and Comparative Example 2 was evaluated under simulated sunlight. The light, at 1 sun intensity, was projected onto the solar cells with a solar simulator in a manner such that the light entered the solar cells, via a light-blocking mask, from the glass surface side, the glass being the substrate. The light-blocking mask had an opening area shape of 0.4 cm × 0.25 cm. A voltage-current characteristic over a voltage range of -0.2 V to +1.2 V was measured with a source meter (6246, manufactured by ADC Corporation), and the power at a maximum power point was determined. Table 2 shows the maximum powers of the solar cells of Examples 10 to 18 and Comparative Example 2.

**[Table 2]**

| | Composition of ink for second electrode | | | | | P-type dopant concentration in composition (wt/wt) | 200-lx performance | 1-SUN performance |
|---|---|---|---|---|---|---|---|---|
| | Acetylene black (g) | Cellulose (g) | LiTFSI (g) | TPFPB (g) | 2-Propanol (g) | | Current at Vop=0.6 V (µA/cm²) | Maximum power mW/cm² |
| Comparative Example 2 | 9.0 | 1.0 | 0.00 | 0.00 | 30.7 | 0 | 16.5 | 5.08 |
| Example 10 | 9.0 | 1.0 | 0.00 | 0.04 | 30.8 | 0.001 | 23.9 | 11.06 |
| Example 11 | 9.0 | 1.0 | 0.00 | 0.17 | 31.0 | 0.004 | 23.8 | 10.55 |
| Example 12 | 9.0 | 1.0 | 000 | 1.62 | 33.2 | 0.036 | 24.2 | 11.55 |
| Example 13 | 9.0 | 1.0 | 0.00 | 4.85 | 38.1 | 0.091 | 24.2 | 10.12 |
| Example 14 | 9.0 | 1.0 | 0.00 | 9.69 | 45.5 | 0.149 | 24.0 | 11.18 |
| Example 15 | 9.0 | 1.0 | 000 | 17.4 | 30.7 | 0.299 | 23.2 | 10.24 |
| Example 16 | 9.0 | 1.0 | 000 | 34.8 | 30.7 | 0.461 | 24.0 | 11.45 |
| Example 17 | 9.0 | 1.0 | 1.62 | 000 | 33.2 | 0.036 | 23.4 | 10.14 |
| Example 18 | 9.0 | 1.0 | 4.85 | 000 | 38.1 | 0.091 | 18.9 | 10.96 |

### (Discussion 2)

As shown in Table 2, the values regarding Evaluation 3 and Evaluation 4 of Examples 10 to 16 are greater than the values regarding Evaluation 1 and Evaluation 2 of Comparative Example 2. The use of the ink for an electrode containing TPFPB, which is a p-type dopant, for the formation of the second electrode improves the properties of the solar cells. Furthermore, the properties of the solar cells are improved when the concentration of TPFPB in the ink for an electrode is within a range of greater than or equal to 0.1 mass% and less than or equal to 46.1 mass%.

The current values regarding Evaluation 3 and the values of the maximum power regarding Evaluation 4 of Examples 17 and 18 are greater than those of Comparative Example 2. This indicates that even when the p-type dopant included in the ink for an electrode is LiTFSI while the p-type dopant originally included in the hole transport layer is TPFPB, the properties of the solar cells are improved. That is, it was demonstrated that the p-type dopant to be included in the ink for an electrode is not limited to the p-type dopant present in the hole transport layer, that is, may be a different material. Furthermore, from Tables 1 and 2, it is apparent that the use of the ink for an electrode containing a p-type dopant for the formation of the second electrode improves the properties of electronic devices, regardless of the type of the p-type dopant included in the hole transport layer.

### Industrial Applicability

The composition and the manufacturing methods of the present disclosure provide electronic devices having improved performance in terms of initial and long-term reliability, compared with those of the related art, and are, therefore, useful.

### Reference Signs List

1, 11 substrate
2, 12 first electrode
3, 13 electron transport layer
4, 14 photoelectric conversion layer
5, 15 hole transport layer
6, 16 second electrode
7, 17 auxiliary electrode
100, 200, 300, 400 solar cell

## Claims

1. A composition comprising:
a conductive material;
a p-type dopant; and
a solvent, wherein
the solvent comprises at least one compound selected from the group consisting of alcohols, aliphatic hydrocarbons, siloxanes, esters, and ethers.

2. The composition according to claim 1, wherein the conductive material comprises at least one selected from the group consisting of metals, conductive carbons, and conductive compounds.

3. The composition according to claim 1 or 2, wherein the p-type dopant comprises at least one selected from the group consisting of metal salts comprising a bis(trifluoromethanesulfonyl)imide group; metal salts comprising a bis(fluorosulfonyl)imide group; metal salts comprising a bis(pentafluoroethylsulfonyl)imide group; metal salts comprising a 4,4,5,5-tetrafluoro-1,3,2-dithiazolidine-1,1,3,3-tetraoxide group; tris(pentafluorophenyl)borane; 2,3,5,6-tetrafluoro-7,7,8,8-tetracyanoquinodimethane; SnCl₄; SbCl₅; FeCl₃; and WO₃.

4. The composition according to claim 3, wherein the p-type dopant comprises at least one selected from the group consisting of lithium bis(trifluoromethanesulfonyl)imide and tris(pentafluorophenyl)borane.

5. The composition according to any one of claims 1 to 4, wherein the solvent comprises at least one selected from the group consisting of 1-propanol, 2-propanol, 1-butanol, 2-butanol, 1-pentanol, 2-pentanol, 3-pentanol, hexanol, heptanol, octanol, nonanol, decanol, undecanol, dodecanol, 1,2-propanediol, 1,3-propanediol, 1,2-pentadiol, 1,3-pentadiol, hexane, heptane, octane, nonane, decane, undecane, dodecane, hexamethyldisiloxane, hexamethoxydisiloxane, 1,1,3,3-tetramethyldisiloxane, 1,1,3,3,5,5,7,7,9,9,11,11-dodecamethylhexasiloxane, 1,1,5,5-tetramethyl-3,3-diphenyltrisiloxane, 1,1,1,3,3-pentamethyldisiloxane, methyl acetate, ethyl acetate, propyl acetate, butyl acetate, methyl cellosolve, ethyl cellosolve, propyl cellosolve, butyl cellsolve, dimethyl cellosolve, phenyl cellosolve, diisopropyl ether, ethylene glycol monoethyl ether acetate, propylene glycol monomethyl ether acetate, diethylene glycol monobutyl ether acetate, diethylene glycol monoethyl ether acetate, diethylene glycol monomethyl ether, diethylene glycol monoethyl ether, diethylene glycol monobutyl ether, propylene glycol monomethyl ether, propylene glycol monomethyl ether propionate, ethylene glycol dimethyl ether, diethylene glycol dimethyl ether, ethylene glycol diethyl ether, diethylene glycol diethyl ether, triethylene glycol dimethyl ether, diethylene glycol dibutyl ether, tetraethylene glycol dimethyl ether, and dipropylene glycol dimethyl ether.

6. The composition according to claim 5, wherein the solvent comprises 2-propanol.

7. The composition according to any one of claims 1 to 6, wherein a concentration of the p-type dopant in the composition is greater than or equal to 0.1 mass% and less than 100 mass%.

8. The composition according to claim 7, wherein the concentration of the p-type dopant is greater than or equal to 0.1 mass% and less than or equal to 46.1 mass%.

9. A method for manufacturing an electronic device comprising:
(A1) stacking a first electrode, a photoelectric conversion layer, and a hole transport layer in the order stated; and
(B1) forming a second electrode on the hole transport layer with the composition according to any one of claims 1 to 8.

10. The manufacturing method according to claim 9, wherein, in (B1), the second electrode is formed by applying the composition onto the hole transport layer.

11. A method for manufacturing an electronic device comprising:
(A2) forming a second electrode with the composition according to any one of claims 1 to 8; and
(B2) stacking a hole transport layer, a photoelectric conversion layer, and a first electrode on the second electrode in the order stated.

12. The manufacturing method according to claim 11, wherein, in (A2), the second electrode is formed by applying the composition onto a substrate.
